**Europäisches Patentamt**

**European Patent Office**

**Office européen des brevets**

(19)

(11) Veröffentlichungsnummer: **0 096 381**
**B1**

(12) # EUROPÄISCHE PATENTSCHRIFT

(45) Veröffentlichungstag der Patentschrift:
**15.10.86**

(21) Anmeldenummer: **83105487.9**

(22) Anmeldetag: **03.06.83**

(51) Int. Cl.⁴: **H 04 N 5/50**, H 04 H 1/00,
H 03 J 7/18

(54) **Empfangsgerät der Unterhaltungselektronik mit einer elektronisch abstimmbaren Tunerschaltung.**

(30) Priorität: **09.06.82 DE 3221768**

(43) Veröffentlichungstag der Anmeldung:
**21.12.83 Patentblatt 83/51**

(45) Bekanntmachung des Hinweises auf die Patenterteilung:
**15.10.86 Patentblatt 86/42**

(84) Benannte Vertragsstaaten:
**AT DE FR GB IT NL**

(56) Entgegenhaltungen:
**EP-A-0 050 328**
**DE-A-2 750 071**
**DE-A-2 850 733**
**DE-A-3 020 782**

**BILD DER WISSENSCHAFT, Heft 9, September
1982, Stuttgart, GÜNTER BOLLE "ZPS": Zuschauen,
wann immer ich will", Seiten 50-55
ELEKTRONIKER, Nr. 5/1981, Aarau, ANDREW
STAMBERGER: "Programmierbare
Rundfunkempfänger", Seiten EL 17, EL 18**

(73) Patentinhaber: **International Standard Electric
Corporation, 320 Park Avenue, New York New
York 10022 (US)**

(84) Benannte Vertragsstaaten: **FR GB IT NL AT**

(73) Patentinhaber: **Standard Elektrik Lorenz
Aktiengesellschaft, Hellmuth- Hirth- Strasse 42,
D-7000 Stuttgart 40 (DE)**

(84) Benannte Vertragsstaaten: **DE**

(72) Erfinder: **Schröder, Wolfgang, Allensteiner Strasse
13, D-7530 Pforzheim (DE)**

(74) Vertreter: **Pohl, Heribert, Dipl.- Ing, Standard
Elektrik Lorenz AG Patent- und Lizenzwesen
Kurze Strasse 8 Postfach 300 929, D-7000
Stuttgart 30 (DE)**

## Beschreibung

Die Erfindung betrifft ein Empfangsgerät der im Oberbegriff des Patentanspruches 1 oder des Patentanspruches 2 angegebenen Art. Ein derartiges Empfangsgerät ist beispielsweise aus der DE-A1-30 20 787 bekannt. An den Signalweg zur Übertragung eines Videosignales des bekannten Empfangsgerätes ist über einen Verstärker eine Datenabtrennstufe angeschlossen, die einen in den Videosignalen enthaltenen Datensatz erkennt und aus den Videosignalen heraustrennt. Die Datenabtrennstufe wird bei der bekannten Empfangsschaltung von einer Fensterschaltung gesteuert, die die Datenabtrennstufe abhängig vom zeitlichen Abstand von den Bildsynchronimpulsen auftastet, so daß diese nur auf die in den zugeordneten Zeilen übertragenen zusätzlichen Informationen anspricht. Der von der Datenabtrennstufe abgetrennte Datensatz enthält neben einem die Art des abgetrennten Datensatzes kennzeichnenden Satzkennwort den empfangenen Sender kennzeichnende Informationen und dessen übertragenes Programm kennzeichnende Informationen sowie gegebenenfalls weitere Informationen über Sender und deren zur Zeit ausgestrahltes Programm. Die in der Datenabtrennstufe aufgeschlüsselten Informationen und der daraus gebildete Abruftakt werden in der bekannten Empfangsschaltung an eine Auswertschaltung übertragen, die eine Tastatur zur Programmierung der Auswertschaltung enthält.

Aus der Druckschrift "Technische Informationen für die Industrie" Nr. 800407 der Firma VALVO ist ein in einem Fernsehempfangsgerät verwendeter Videotextdecoder bekannt, der ebenfalls eine an den Signalweg des Fernsehempfangsgerätes angeschlossene Datenabtrennschaltung enthält. Mit den Videotextdaten wird ein Generator für den Abruftakt synchronisiert. In einem Vergleicher werden die Videotextdaten beim Durchlauf mit vorgewählten und festen Daten eines von einer Fernbedienung programmierbaren Speichers verglichen und mittels des Vergleichsergebnisses die Einspeicherung in einen Datenspeicher gesteuert. Für diesen Einschreibvorgang enthält der Datenspeicher eine Einlesesteuerschaltung. Das Auslesen des Datenspeichers in einen Zeichengenerator der bekannten Anordnung wird von einer Auslesesteuerschaltung gesteuert, an den ein Taktgenerator für den Auslesetakt angeschlossen ist.

Der Erfindung liegt die Aufgabe zugrunde, für ein Empfangsgerät der eingangs angegebenen Art die Auswertschaltung für einen mittels einer Datenabtrennschaltung aus dem Signalgemisch eines Signalweges des Empfangsgerätes abgetrennten Datensatz für die Senderprogrammerkennung für eine vorgewählte Sendereinstellung herzustellen. Für diese Aufgabe geben nach der Erfindung die Merkmale des kennzeichnenden Teiles des ersten Patentanspruches eine erste Lösung und die Merkmale des kennzeichnenden Teiles des zweiten Patentanspruches eine zweite Lösung an.

Mit den Maßnahmen nach der Erfindung wird eine besonders einfache Ausgestaltung insbesondere der Auswertschaltung erreicht, die dennoch ein stetes Abfragen des Senderprogrammes in kurzen Zeitintervallen und eine schnelle, selbsttätige Abstimmung auf den ausgewählten Sender erlaubt, wenn eine Übereinstimmung mit den ausgewählten Programmdaten und den empfangenen Senderdaten in der Vergleichsschaltung erkannt wird. Außerdem ist das erfindungsgemäße Empfangsgerät so ausgebildet, daß es Bestandteil eines Mikroprozessors sein kann.

In den abhängigen Ansprüchen sind vorteilhafte Ausgestaltungen der Erfindung angegeben.

Die Erfindung wird nachfolgend anhand einiger vorteilhafter Ausführungsbeispiele näher erläutert. In den zugehörigen Zeichnungen zeigen

Fig. 1 und 3 je ein in einem Blockschaltbild schematisch dargestelltes Empfangsgerät zur Auswertung eines empfangenen, in Fig. 2 schematisch dargestellten Senderprogrammdatensatzes,

Fig. 2 ein in Blocksymbolen schematisch dargestellter Senderprogrammdatensatz,

Fig. 4 ein in Blocksymbolen schematisch dargestellter Senderprogrammdatensatz für das übertragene Programm mehrerer Sender,

Fig. 5 ein in einem Blockschaltbild schematisch dargestelltes Empfangsgerät zur Auswertung eines empfangenen, in Fig. 4 schematisch dargestellten Senderprogrammdatensatzes.

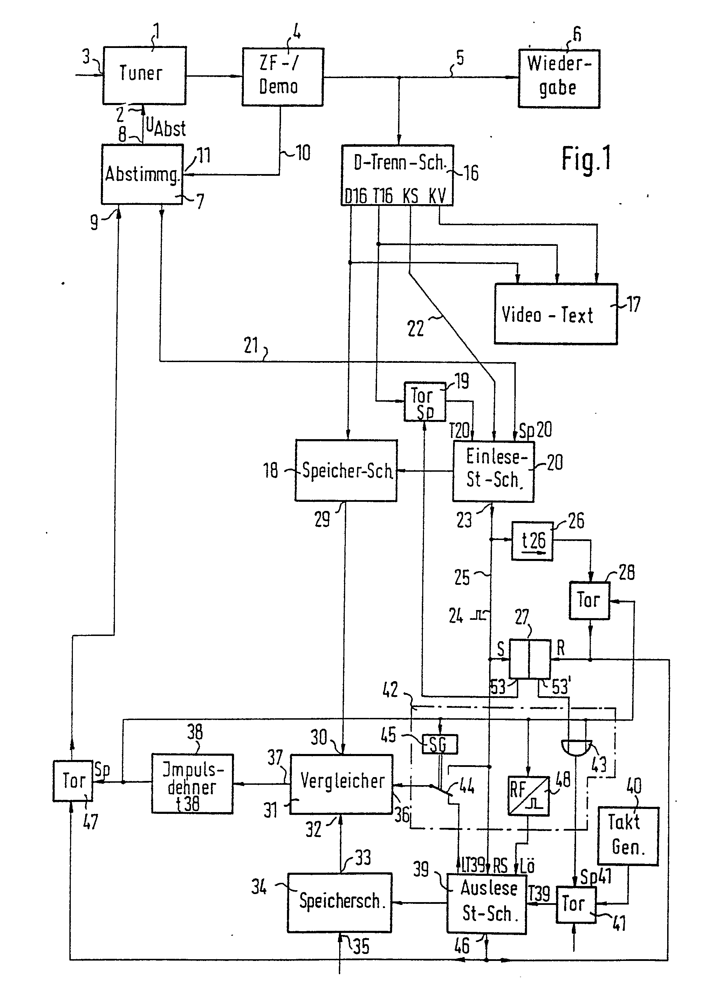

Das in Fig. 1 dargestellte Ausführungsbeispiel eines Empfangsgerätes zum Empfang von Rundfunk- und/oder Fernsehsendungen enthält eine Tunerschaltung 1, die mittels eines Abstimmsignales $U_{Abst}$ an einem Abstimmeingang 2 auf einen Sender einer an ihrem Antenneneingang 3 empfangenen Trägerwelle abstimmbar ist und daraus ein Zwischenfrequenzsignal an eine nachgeschaltete ZF- und Demodulatorschaltung 4 weiterleitet. Die Schaltung 4 erzeugt auf einem Signalweg 5, der in eine Wiedergabeschaltung 6 übergeht, ein Signalgemisch. An den Abstimmeingang 2 der Tunerschaltung 1 ist der Abstimmausgang 8 einer Abstimmschaltung 7 angeschlossen. Im dargestellten Ausführungsbeispiel ist die Abstimmschaltung 7 eine Suchlaufschaltung, die durch ein Signal an einem Starteingang 9 in Lauf gesetzt wird und beispielsweise durch ein Diskriminatorsignal aus der Schaltung 4 über eine Leitung 10 an einem Stopeingang 11 stillgesetzt und nachgestimmt wird.

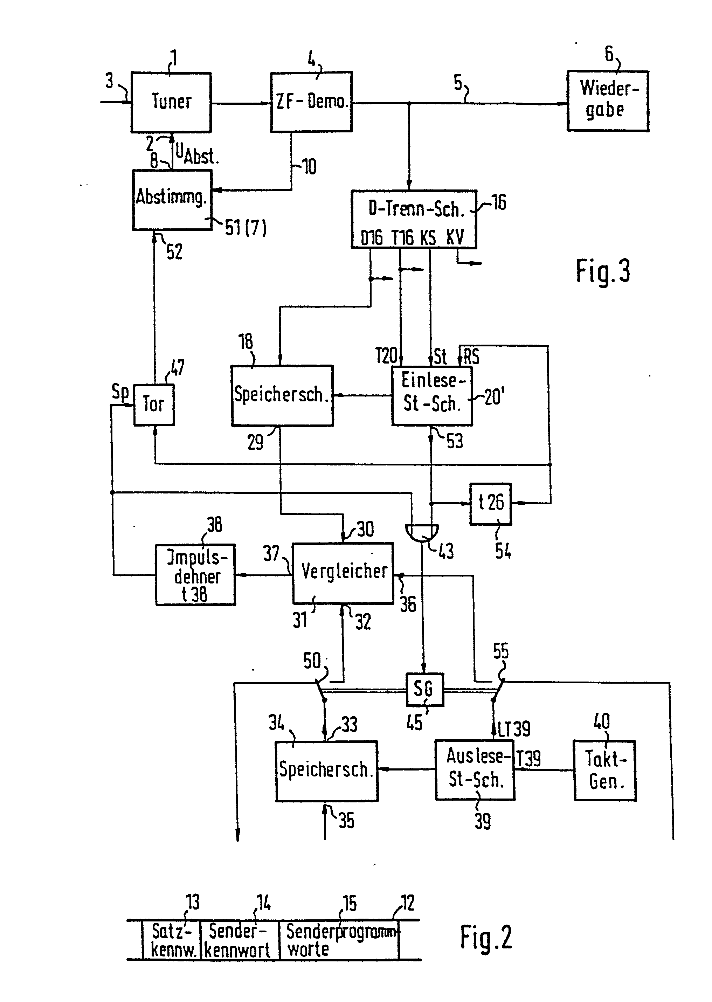

In dem auf dem Signalweg 5 befindlichen Signalgemisch der vom Sender, auf den die Tunerschaltung 1 abgestimmt ist, übertragenen Sendung befindet sich in einer besonderen Signalform ein in Fig. 2 schematisch dargestellter Senderprogrammdatensatz 12, der zur Kennung der Datensatzart ein Satzkennwort 13 enthält. Dem Satzkennwort ist ein Senderkennwort 14 nachgestellt, das den empfangenen Sender kennzeichnet. Daran schließen sich Senderprogrammworte 15 an, die beispielsweise die laufende Sendung des gekennzeichneten Senders durch eine Programmnummer oder durch die in dem Sendeprogramm des Senders vorgesehenen Daten des Tages und der Uhrzeit der Sendung kennzeichnen. Zur Abtrennung dieses Datensatzes aus dem Signalgemisch ist an den Signalweg 5 eine Datenabtrennschaltung 16 angeschlossen, die im dargestellten Ausführungsbeispiel die Datenabtrennschaltung eines Videotextdecoders 17 ist und bei einem Videotext-Datensatz an einem Ausgang KV ein Ausgangssignal erzeugt und bei einem Senderprogramm-Datensatz 12 an einem Ausgang KS ein Ausgangssignal erzeugt. Außerdem bildet sie an einem Datenausgang D16 die in dem Datensatz 12 enthaltenen Datenworte in einer vorgegebenen Reihenfolge und an einem Taktausgang T16 den aus der Übertragung des Datensatz gebildeten Abruftakt für eine Einspeicherung in eine an den Datenausgang D16 angeschlossene Speicherschaltung 18. Der Abruftakt der Datenabtrennschaltung gelangt über eine Torschaltung 19 an den Takteingang T20 einer Einlesesteuerschaltung 20 der Speicherschaltung 18. Die Einlesesteuerschaltung 20 ist während des Laufes der Suchlaufschaltung 7 über eine Sperrleitung 21 gesperrt und wird im ungesperrten Zustand über eine Steuerleitung 22 von der Datenabtrennschaltung 16 gesteuert. Die Einlesesteuerschaltung 20 steuert gemäß dem Abruftakt und dem Steuersignal am Ausgang KS der Datenabtrennschaltung die Einspeicherung in die Speicherschaltung 18. Sobald die Speicherschaltung 18 auslesebereit ist, erzeugt die Einlesesteuerschaltung 20 an einem Ausgang 23 einen kurzzeitigen Leseimpuls 24, der über eine Leitung 25 eine Impulsverzögerungsschaltung 26 auslöst und eine bistabile Kippschaltung 27 in die Setzlage S kippt. Die Schaltungen 26 und 27, sowie die der Schaltung 26 nachgeschaltete Torschaltung 28 sind Bestandteile der Einlesesteuerschaltung 20.

An den Datenausgang 29 der Speicherschaltung 18 für die empfangenen Senderprogrammdaten ist an einem Dateneingang 30 eine Vergleicherschaltung 31 angeschlossen, deren zweiter Dateneingang 32 an den Datenausgang 33 einer Speicherschaltung 34 für ausgewählte Senderprogrammdaten angeschlossen ist. In die Speicherschaltung 34 sind über deren Dateneingang 35 in nicht näher angegebener Weise die Programmdaten der Sendungen und Sender eingespeichert, die ein Benutzer aus Programmankündigungen ausgewählt und in das Empfangsgerät eingegeben hat. Bei einem Steuersignal an seinem Steuereingang 36 erzeugt die Vergleicherschaltung 31 an ihrem Ausgang 37 ein Signal, wenn die Daten an ihren Dateneingängen 30 und 32 zum Vergleichszeitpunkt übereinstimmen. Jedes Ausgangssignal der Vergleicherschaltung 31 wird in einer nachgeschalteten Impulsdehnerschaltung 38 auf eine in dieser eingestellte Impulsbreite t38 ausgedehnt. Eine Auslesesteuerschaltung 39, die von einem Taktgenerator 40 über eine Torschaltung 41 an einem Takteingang T39 getaktet wird, steuert die Speicherschaltung 34 für die ausgewählten Senderprogrammdaten so, daß mit jedem Takt die Programmdaten einer neuen Speicherzeile der Speicherschaltung 34 an den Dateneingang 32 der Vergleicherschaltung 31 gelangen. Zwischen den Ausgängen der Einlesesteuerschaltung 20 bis 28, dem Steuereingang der Vergleicherschaltung 31 und den Ein- und Ausgängen der Auslesesteuerschaltung 39 und 41 sowie dem Ausgang der Impulsdehnerschaltung 38 ist eine logische Verknüpfungsschaltung 42 angeordnet, die im dargestellten Ausführungsbeispiel im wesentlichen eine Oderschaltung 43 und einen elektronischen Umschalter 44 mit einem elektronischen Stellglied 45 enthält.

Der Leseimpuls 24 der Einlesesteuerschaltung 20 stellt die Auslesesteuerschaltung 39 an ihren Rückstelleingang RS in die Anfangsstellung zurück. Die gekippte bistabile Kippschaltung 27 hebt die Sperrung am Sperreingang Sp41 der Torschaltung 41 auf, so daß der Taktgenerator 40 die Auslesesteuerschaltung 39 taktet und damit nacheinander die in der Speicherschaltung 34 gespeicherten ausgewählten Senderprogrammdaten an den Dateneingang 32 der Vergleicherschaltung 31 bringt. Gleichzeitig erzeugt der Takt des Taktgenerators 40 an einem Lesetaktausgang LT39 der Auslesesteuerschaltung 39 Lesetaktsignale, die über den Umschalter 44 an den Takteingang 36 der Vergleicherschaltung 31 gelangen. Wird in der Vergleicherschaltung 31 kein Vergleich festgestellt, läuft die Auslesesteuerschaltung 39 sämtliche belegten Speicherzeilen der Speicherschaltung 34 durch und erzeugt am Ende ihres Durchlaufes an einem Endeausgang 46 ein Steuersignal, das die bistabile Kippschaltung 27 in die RS-Lage zurückstellt und somit die Taktimpulse des Taktgenerators 40 am Sperreingang Sp41 der Torschaltung 41 sperrt und das über eine Torschaltung 47 als Startsignal am Starteingang 9 der Abstimmschaltung 7 einen erneuten Suchlauf auslöst.

Sobald am Ausgang 37 der Vergleicherschaltung 31 infolge Gleichheit der an den Dateneingängen 30 und 32 anliegenden zu vergleichenden Senderprogrammdaten ein Ausgangssignal erzeugt wird, sperrt das Ausgangssignal der Impulsdehnerschaltung 38 über die Oderschaltung 43 und die Torschaltung 41 die Taktsignale des Taktgenerators 40 zur Speicherschaltung 34, schaltet den Steuereingang 36 der Vergleicherschaltung über den Umschalter 44 an den Leseausgang 23 der Einlesesteuerschaltung 20 um und schaltet die Torschaltung 28 für die Ausgangssignale der Impulsverzögerungsschaltung 26 durchlässig. Ein Ausgangsimpuls der Impulsverzögerungsschaltung 26 kippt die bistabile Kippschaltung 27 in die RS-Lage zurück, so daß ein neuer Einlesevorgang über die bisher gesperrte Torschaltung 19 an der Einlesesteuerschaltung 20 ausgelöst wird. Die Verzögerungszeit t26 der Impulsverzögerungsschaltung 26 bestimmt die Intervallzeit, die zwischen zwei aufeinanderfolgenden Einspeicherungen in die Speicherschaltung 18 liegt. Die Impulsbreite t38 der Impulsdehnerschaltung 38 beträgt im dargestellten Ausführungsbeispiel ein Mehrfaches der Verzögerungszeit t26, um sicherzustellen, daß bei einem fehlerhaften Ausbleiben eines Vergleichssignals am Ausgang 37 der Vergleicherschaltung 31 der Stillhaltezustand der Schaltungsanordnung nicht verändert wird. Die in diesem Zustand gesperrte Torschaltung 47 verhindert, daß ein Endesignal am Ausgang 46 der Auslesesteuerschaltung 39 den Starteingang 9 der Abstimmschaltung 7 erreicht.

Ist die ausgewählte und vom Sender, auf den der Tuner 1 abgestimmt ist, ausgestrahlte Sendung beendet, dann werden auch die vom Sender übertragenen, die Sendung kennzeichnenden Programmworte nicht mehr übertragen, so daß von da ab am Ausgang 37 der Vergleicherschaltung 31 keine Ausgangsimpulse mehr auftreten und das Ausgangssignal der Impulsdehnerschaltung nach der Impulsdehnungszeit t38 abbricht. Die Rückflanke des Ausgangssignals der Impulsdehnerschaltung 38 erzeugt in einer Differenzierschaltung 48 einen Ausgangsimpuls, der in dem dargestellten Ausführungsbeispiel an einen Löscheingang Lö39 der Auslösesteuerschaltung 39 gelangt und die am Ausgang der Speicherschaltung 34 liegende Speicherzeile löscht.

Das in Fig. 3 als Ausführungsbeispiel dargestellte Empfangsgerät unterscheidet sich von dem in Fig. 1 dargestellten Empfangsgerät im wesentlichen darin, daß der Datenausgang 33 der Speicherschaltung 34 für die ausgewählten Senderprogrammdaten über einen elektronischen Umschalter 50 während des Vergleiches an den Dateneingang 32 der Vergleicherschaltung 31 angeschlossen ist und daß die Abstimmschaltung 7 ein fortschaltbarer Festsenderspeicher 51 ist, an dessen Takteingang 52 jeder Taktimpuls den folgenden gespeicherten Festsender zur Abstimmung aufruft. Die Lesesteuerschaltung 20' erzeugt an ihrem Leseausgang 53 ein Lesesignal, das während der gesamten Zeit, in der die in der Programmspeicherschaltung 18 gespeicherten Senderprogrammdaten an dessen Datenausgang 29 zur Verfügung stehen, ansteht. Anstelle der Impulsverzögerungsschaltung 26 des in Fig. 1 dargestellten Ausführungsbeispieles enthält das in Fig. 3 dargestellte Ausführungsbeispiel einen Zeitschalter 54, der nach einer Verzögerungszeit t26 ein Ausgangssignal zur Rückstellung der Einlesesteuerschaltung 20' und als Fortschaltsignal am Takteingang 52 der fortschaltbaren Festsenderspeicherschaltung 51 erzeugt. Das Fortschaltsignal für die Abstimmspannungsschaltung wird somit nicht wie bei dem in Fig. 1 dargestellten Ausführungsbeispiel vom Endeausgang 46 der Auslesesteuerschaltung 39 erzeugt.

Während der Zeit, in der ein Vergleich der Vergleicherschaltung erwartet wird, d.h. in der Zeit, in der die Einlesesteuerschaltung an ihrem Leseausgang 53 ein Signal erzeugt oder während der die Impulsdehnerschaltung 38 ein Signal erzeugt, wird der Datenausgang 33 der Speicherschaltung 34 über dem elektronischen Umschalter 50 an den Dateneingang 32 der Vergleicherschaltung angeschlossen und der Lesetaktausgang LT39 über einen elektronischen Umschalter 55 an den Steuereingang 36 der Vergleicherschaltung 31 angeschlossen. Die Umschaltung der beiden Umschalter 50 und 55 wird über die Oderschaltung 43 und das Stellglied 45 bewirkt. Die Speicherschaltung 34 für die ausgewählten Senderprogrammdaten wird mittels des Taktgenerators 40 dauernd durchgetaktet, so daß bei jedem Durchlauf der Speicherschaltung 34 am Ausgang 37 der Vergleicherschaltung 31 ein Ausgangssignal entsteht, wenn die Speicherschaltung 18 für die empfangenen Senderprogrammdaten die gleichen Senderprogrammdaten enthält wie die Speicherschaltung 34 in einer auslesbaren Speicherzeile. Im nicht umgeschalteten Zustand der elektronischen Umschalter 50 und 55 steht die Speicherschaltung 34 mit ihrer Auslesesteuerschaltung 39 weiteren, nicht näher bezeichneten Einrichtungen des Empfangsgerätes zur Verfügung.

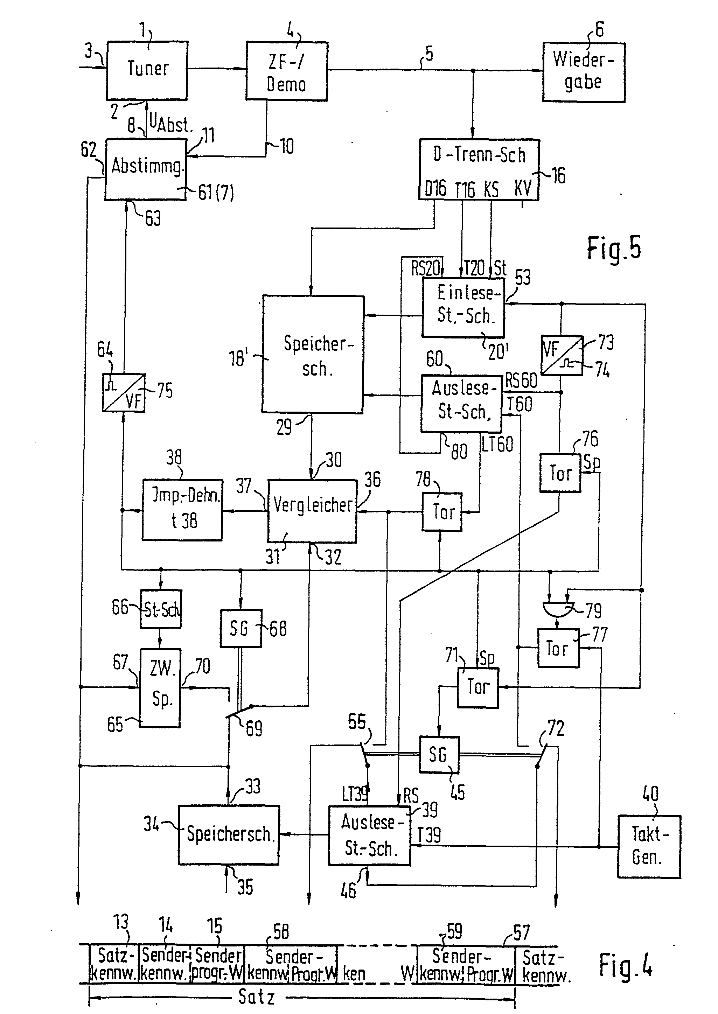

In Fig. 4 ist ein Senderprogrammdatensatz 57 dargestellt, der neben dem Satzkennwort 13 und den Senderprogrammdaten 14 und 15 des den Datensatz 57 übertragenden Senders auch Senderprogrammdaten 58 und 59 anderer Sender zur Kennzeichnung gleichzeitig laufender Sendungen anderer Sender enthält. Zur Auswertung eines derartigen Senderprogrammdatensatzes 57 ist ein Empfangsgerät geeignet, das als Ausführungsbeispiel der Erfindung in Fig. 5 dargestellt ist. Den Ausführungsbeispielen der Figuren 1 und 3 entsprechende Schaltungsanordnungen sind in Fig. 5 mit den gleichen Bezugszeichen gekennzeichnet. Die Speicherschaltung 18' für die empfangenen Senderprogrammdaten ist so programmiert, daß sie für das Senderkennwort 14 und die Senderprogrammworte 15 jedes Senders eine auslesbare Speicherzeile enthält, die mittels einer Ausleseschaltung 60 an den Datenausgang 29 der Speicherschaltung anlegbar sind. Unabhängig davon ist in dem dargestellten Ausführungsbeispiel die Abstimmschaltung 7 eine Senderdaten-Analogwandler-Schaltung 61, die beispielsweise aus einem an ihren Dateneingang 62 angelegten Senderkennwort und einem an ihren Steuereingang 63 angelegten Steuerimpuls 64 bis zum Eintreffen eines neuen Steuerimpulses die zugehörige Abstimmspannung $U_{Abst}$ erzeugt. Ferner enthält im dargestellten Ausführungsbeispiel die Speicherschaltung 34 für die ausgewählten Senderprogrammdaten an ihrem Datenausgang 33 einen Zwischenspeicher 65, der von einer Steuerschaltung 66 gesteuert wird und dessen Dateneingang 67 an den Datenausgang 33 der Speicherschaltung 34 angeschlossen ist. Der Dateneingang 32 der Vergleicherschaltung 31 ist wahlweise über einen von einem elektronischen Stellglied 68 umschaltbaren elektronischen Schalter 69 an den Datenausgang 33 der Speicherschaltung 34 oder den Datenausgang 70 des Zwischenspeichers 65 anschaltbar.

Nach dem Einlesevorgang der empfangenen Senderprogrammdaten in die Speicherschaltung 18' erzeugt die Einlesesteuerschaltung 20' an ihrem Leseausgang 53 ein Lesesignal, das über eine Torschaltung 71 und das Stellglied 45 die beiden die Lesesteuerschaltung 39 der Speicherschaltung 34 umschaltenden elektronischen Umschalter 55 und 72 umschaltet und dadurch den Endeausgang 46 der Auslesesteuerschaltung 39 für die Speicherschaltung 34 an den Takteingang T60 der Auslesesteuerschaltung 60 für die Speicherschaltung 18' anschließt und den Lesetaktausgang LT39 an den Steuereingang 36 der Vergleicherschaltung 31 anschließt. Außerdem wird mittels eines die Vorderflanke des Lesesignals der Einlesesteuerschaltung differenzierenden Differenziergliedes 73 ein Rückstellsignal 74 für die beiden Auslesesteuerschaltungen 60 und 39 erzeugt. Der Taktgenerator 40 taktet die Auslesesteuerschaltung 39 für die Speicherschaltung 34 und über deren Lesetaktausgang LT39 und den Umschalter 72 den Steuereingang 36 der Vergleicherschaltung 31. Die nach einem Durchlauf der ersten Auslesesteuerschaltung 39 an deren Endeausgang 46 erzeugten Signale takten die zweite Auslesesteuerschaltung 60 der Speicherschaltung 18. Wird in der Vergleicherschaltung an deren Ausgang 37 kein Signal erzeugt, dann erzeugt die zweite Auslesesteuerschaltung 60 an ihrem Endeausgang 80 ein Ausgangssignal, das die Einlesesteuerschaltung 20' an ihrem Rückstelleingang RS20 in die Anfangsstellung einstellt. Erzeugt dagegen die Vergleicherschaltung 31 an ihrem Ausgang 37 ein Vergleichssignal, dann werden mit der Vorderflanke des unmittelbar danach am Ausgang der Impulsdehnerschaltung 38 auftretenden Ausgangssignals über die Steuerschaltung 66 die am Datenausgang 33 der Speicherschaltung 34 anliegenden Daten in den Zwischenspeicher 65 eingespeichert und in einer Differenzierschaltung 75 der Steuerimpuls 64 für die Erzeugung der Abstimmspannung in der Schaltung 61 erzeugt. Das Ausgangssignal der Impulsdehnerschaltung 38 schaltet über das Stellglied 68 und den Umschalter 69 den Dateneingang 32 der Vergleicherschaltung 31 an den Datenausgang 70 des Zwischenspeichers 65 und sperrt gleichzeitig über die Torschaltung 71 das Steuersignal zum Stellglied 45 der elektronischen Umschalter 55 und 72. Dadurch ist die Speicherschaltung 34 für die ausgewählten Senderprogrammdaten und die zugehörige Lesesteuerschaltung frei für weitere Anwendungen in dem dargestellten Empfangsgerät. Eine Torschaltung 76 verhindert während der Dauer des Ausgangssignals der Impulsdehnerschaltung eine Rückstellung der Auslesesteuerschaltung 39. Eine weitere Torschaltung 77 verbindet den Ausgang des Taktgenerators mit dem Takteingang T60 der Auslesesteuerschaltung 60 der Speicherschaltung 18' und eine ebenso angesteuerte Torschaltung 78 verbindet den Lesetaktausgang LT60 der zweiten Auslesesteuerschaltung 60 mit dem Steuereingang 36 der Vergleicherschaltung 31. Eine dem Steuereingang der Torschaltung 77 vorgeschaltete Und-Schaltung 79, deren zweiter Eingang an den Leseausgang 53 der Einlesesteuerschaltung 20' angeschlossen ist, bewirkt, daß die zweite Auslesesteuerschaltung 60 während der Dauer des Ausgangssignals der Impulsdehnerschaltung nur in dem Zeitraum von dem Taktgenerator 40 getaktet wird, in dem die Einlesesteuerschaltung 20' an ihrem Leseausgang 53 ein Signal erzeugt, d.h. außerhalb des Ablaufvorganges der Einlesesteuerschaltung 20'. Nach dem Durchlauf der zweiten Auslesesteuerschaltung 60 erzeugt diese an ihrem Endeausgang 80 ein Rückstellsignal für die Einlesesteuerschaltung 20'.

Während des Durchlaufes der zweiten Auslesesteuerschaltung 60 erzeugt die Vergleicherschaltung 31 ein Ausgangssignal, solange vom Sender, auf den die Tunerschaltung 1 abgestimmt ist, die in dem Zwischenspeicher 65 gespeicherten Programmdaten im Senderprogrammdatensatz 57 übertragen werden. Die Impulsbreite t38 der in der Impulsdehnerschaltung 38 gedehnten Impulse beträgt im dargestellten Ausführungsbeispiel ein Mehrfaches der Summe der Durchlaufzeit der Einlesesteuerschaltung 20' und der Durchlaufzeit der zweiten Auslesesteuerschaltung 60. Die Rückflanke des Ausgangssignales der Impulsdehnerschaltung 38 bewirkt durch die Steuerschaltung 66, daß die im dem Zwischenspeicher 65 gespeicherten Senderprogrammdaten gelöscht werden

Wird in einen weiteren Ausführungsbeispiel eines erfindungsgemäßen Empfangsgerätes auf einen Zwischenspeicher 65 am Ausgang der Speicherschaltung 34 verzichtet, dann wird während der Dauer des Ausgangssignales der Impulsdehnerschalter 38 jewils in dem Zeitraum jewils außerhalb des Einlesvorganges der Einlesesteuerschaltung 20' die eine Auslesesteuerschaltung, Beispielweise 39, vom Taktgenerator 40 getaktet und die zweite Auslesesteuerschaltung, beispieleweise 60, vom dem Endesignal am Ende des Auslesevorganges der ersten Auslesesteuerschaltung getaktet. Dadurch wird jede Speicherzeile der einen Speicherschaltung mit jeder Speicherziele der anderen Speicherschaltung in der Vergleicherschaltung 31 verglichen.

**Bezugszeichen**

1 Tunerschaltung
2 Abstimmeingang
3 Antenneneingang
4 ZF- und Demodulatorschaltung
5 Signalweg
6 Wiedergabeschaltung
7 Abstimmschaltung
8 Abstimmausgang
9 Starteingang
10 Leitung
11 Stopeingang
12 Senderprogrammdatensatz
13 Satzkennwort
14 Senderkennwort
15 Senderprogrammworte
16 Datenabtrennschaltung
17 Videotextdecoder
18 Speicherschaltung
19 Torschaltung
20 Einlesesteuerschaltung
21 Sperrleitung
22 Steuerleitung
23 Leseausgang
24 Leseimpuls
25 Leitung
26 Impulsverzögerungsschaltung
27 bistabile Kippschaltung
28 Torschaltung
29 Datenausgang
30 Dateneingang
31 Vergleicherschaltung
32 Dateneingang
33 Datenausgang
34 Speicherschaltung
35 Dateneingang
36 Steuereingang
37 Ausgang
38 Impulsdehnerschaltung
39 Auslesesteuerschaltung
40 Taktgenerator
41 Torschaltung
42 logische Verknüpfungsschalt
43 Oderschaltung
44 elektrischer Umschalter
45 elektronisches Stellglied
46 Endeausgang
47 Torschaltung
48 Differenzierschaltung
50 elektronischer Umschalter
51 Festsenderspeicherschaltung
52 Takteingang
53 Leseausgang

54 Zeitschalter
55 elektronischer Umschalter
57 Senderprogrammdatensatz
58 Senderprogrammdaten

**Fortsetzung Bezugszeichen**

59 Senderprogrammdaten
60 Ausleseschaltung
61 Senderdaten-Analogwandler-Schaltung
62 Dateneingang
63 Steuereingang
64 Steuerimpuls
65 Zwischenspeicher
66 Steuerschaltung
67 Dateneingang
68 Stellglied, elektronisch
69 elektronischer Schalter
70 Datenausgang
71 Torschaltung
72 elektronischer Umschalter
73 Differenzierglied
74 Rückstellimpuls
75 Differenzierschaltung
76 Tonschaltung
77 Tonschaltung
78 Tonschaltung
79 Undschaltung
80 Endeausgang

**Patentansprüche**

1. Empfangsgerät der Unterhaltungselektronik
 - mit einer elektronisch abstimmbaren Tunerschaltung (1),
 - ferner mit einer an einen Abstimmeingang (2) der Tunerschaltung angeschlossenen, selbsttätig einstellbaren Abstimmschaltung (7, 51), die einen Starteingang (11) zum Auslösen einer neuen Abstimmeinstellung aufweist,
 - außerdem mit einer Datenabtrennschaltung(l6), die an einen der Tunerschaltung (1) nachgeschalteten Signalweg (5) angeschlossen ist und die aus einem auf dem Signalweg (5) befindlichen Signalgemisch einen durch ein Satzartkennwort (13) gekennzeichneten, Senderkennungsworte (14) und Sendeprogrammworte (15) in digitaler Zeichenform enthaltenden Senderprogrammdatensatz (12) abtrennt, die ferner an einem Datenausgang (D 16) die in dem Datensatz enthaltenden Datenworte ausgibt und an einem Taktausgang (T 16) den für die Datenausgabe erforderlichen Abruftakt erzeugt,
 - und mit einer an den Datenausgang und den Abruftaktausgang der Datenabtrennschaltung angeschlossenen Auswerteschaltung, in der ausgewählte Sendeprogrammdaten gespeichert sind und in der die Daten des empfangenen Sendeprogrammdatensatzes anhand der ausgewählten Sendeprogrammdaten ausgewertet werden,
dadurch gekennzeichnet,
- daß die Auswertschaltung eine an den Datenausgang (D16) der Datenabtrennschaltung (16) angeschlossene erste Speicherschaltung (18) für die empfangenen Senderprogrammdaten (14, 15) und eine daran angeschlossene Einlesesteuerschaltung (20), eine zweite Speicherschaltung (34) für die gewählten Senderprogrammdaten und eine daran angeschlossene, von einem Taktgenerator (40) gesteuerte Auslesesteuerschaltung (39) und eine zwischen die Datenausgänge (29, 33) der beiden Speicherschaltungen geschaltete Vergleicherschaltung (31) enthält,
- daß der Ausgang (T16) für den Abruftakt der Datenabtrennschaltung mit einem Takteingang (T20) der Einlesesteuerschaltung (20) verbunden ist,
- daß an die Einlesesteuerschaltung (20) eine Impulsverzögerungsschaltung (26, 54) angeschlossen ist, die von einem Signal der Einlesesteuerschaltung (20) auslösbar ist und nach einer Zeitverzögerung (t26), die gleich oder größer ist als die Summe der nach dem Auslösesignal noch verbleibenden Einlesezeit in die die erste Speicherschaltung für die empfangenen Senderprogrammdaten und der Auslesezeit der beiden Speicherschaltungen, ein Ausgangssignal erzeugt,
- daß der Ausgang der Impulsverzögerungsschaltung (26, 54) über eine Torschaltung (47) mit dem Starteingang (9, 52) der Abstimmschaltung (7) verbunden ist,
- daß an den Ausgang (37) der Vergleicherschaltung (31') eine Impulsdehnerschaltung (38) angeschlossen ist, die jeden eingangsseitigen Impuls an ihrem Ausgang auf eine Impulsbreite ausdehnt, die größer ist als die Zeit zwischen dem Beginn zweier aufeinanderfolgender Einlesevorgänge in die erste Speicherschaltung (18) für die empfangenen Senderprogrammdaten,
- daß der Ausgang der Impulsdehnerschaltung an den Sperreingang (Sp) der Torschaltung (47) angeschlossen ist und
- daß an einen Lesesignalausgang (53) der Einlesesteuerschaltung (20) und an den Ausgang der Impulsdehnerschaltung (38) eine logische Verknüpfungsschaltung (42) angeschlossen ist, die bei einem Signal an einem der beiden Ausgänge die Vergleicherschaltung (31) wirksam schaltet.

2. Empfangsgerät nach Anspruch 1, dadurch gekennzeichnet, daß der Ausgang der Impulsverzögerungsschaltung (54) mit einem Rückstelleingang (RS, R) der Einlesesteuerschaltung (20, 27; 20') verbunden ist.

3. Empfangsgerät nach Anspruch 1 oder 2, dadurch gekennzeichnet, daß die Impulsverzögerungsschaltung (54) an den Lesesignalausgang (53) der Einlesesteuerschaltung (20') angeschlossen ist.

4. Empfangsgerät der Unterhaltungselektronik
- mit einer elektronisch abstimmbaren Tunerschaltung (1)
- ferner mit einer an einen Abstimmeingang (2) der Tunerschaltung angeschlossenen, selbsttätig einstellbaren Abstimmschaltung (61), die einen Starteingang (62) zum Auslösen einer neuen Abstimmeinstellung aufweist,
- außerdem mit einer Datenabtrennschaltung (16), die an einen der Tunerschaltung nachgeschalteten Signalweg (5) angeschlossen ist und die aus einem auf dem Signalweg befindlichen Signalgemisch einen durch ein Satzartkennwort (13) gekennzeichneten, Senderkennungsworte (14) und Sendeprogrammworte (15) in digitaler Zeichenform enthaltenden Senderprogrammdatensatz abtrennt, die ferner an einem Datenausgang (D16) die in dem Datensatz enthaltenen Datenworte ausgibt und an einem Taktausgang (T16) den für die Datenausgabe erforderlichen Abruftakt erzeugt,
- und mit einer an den Datenausgang und den Abruftaktausgang der Datenabtrennschaltung angeschlossenen Auswertschaltung, in der ausgewählte Sendeprogrammdaten gespeichert sind und in der die Daten des empfangenen Sendeprogrammdatensatzes anhand der ausgewählten Sendeprogrammdaten ausgewertet werden, dadurch gekennzeichnet,
- daß die Auswertschaltung eine an den Datenausgang (D16) der Datenabtrennschaltung (16) angeschlossene erste Speicherschaltung (18) für die empfangenen Senderprogrammdaten (14, 15) und eine daran angeschlossene Einlesesteuerschaltung (20), eine zweite Speicherschaltung (34) für die gewählten Senderprogrammdaten und eine darananangeschlossene, von einem Taktgenerator (40) gesteuerte Auslesesteuerschaltung (39) und eine zwischen die Ausgänge (29, 33) der beiden Speicherschaltungen geschaltete Vergleicherschaltung (31) enthält,
- daß der Ausgang (T16) für den Abruftakt der Datenabtrennschaltung (16) mit einem Takteingang (T20) der Einlesesteuerschaltung verbunden ist,
- daß an den Ausgang (37) der Vergleicherschaltung (31) eine Impulsdehnerschaltung (38) angeschlossen ist, die jeden eingangsseitigen Impuls an ihrem Ausgang auf eine Impulsbreite ausdehnt, die größer ist als die Zeit zwischen dem Beginn zweier aufeinanderfolgender Einlesevorgänge in die erste Speicherschaltung für die empfangenen Senderprogrammdaten,
- daß der Ausgang (32) der Vergleicherschaltung (31) über eine die Vorderflanke des gedehnten Impulses differenzierende Differenzierschaltung (75) an den Starteingang (63) der Abstimmschaltung (61) angeschlossen ist, während ein Abstimmdateneingang (62) der Abstimmschaltung mit dem Datenausgang (33) der zweiten Speicherschaltung (34) für die gewählten Senderprogrammdaten verbunden ist, und

- daß an einen Lesesignalausgang (53) der Einlesesteuerschaltung und an den Ausgang der Impulsdehnerschaltung eine logische Verknüpfungsschaltung (42) angeschlossen ist, die bei einem Signal an einem der beiden Ausgänge die Vergleicherschaltung wirksam schaltet.

5. Empfangsgerät nach einem der vorhergehenden Ansprüche, dadurch gekennzeichnet,
- daß die erste Speicherschaltung (18') für die empfangenen Senderprogrammdaten für das Senderkennwort (14) und die Senderprogrammworte (15) jedes im Senderprogrammdatensatz enthaltenen Senders eine auslesbare Speicherzeile enthält,
- daß an die Speicherschaltung zusätzlich eine weitere Ausleseschaltung (60) angeschlossen ist, deren Takteingang (T60) über einen Schalter (72) der logischen Verknüpfungsschaltung (42) mit dem Ausgang (46) für ein Ablaufeindesignal der ersten Auslesesteuerschaltung (39) verbunden ist,
- und daß dieser Schalter (72) der logischen Verknüpfungsschaltung (42) während der Dauer eines Lesesteuersignals am Lesesignalausgang (53) der Einlesesteuerschaltung elektrisch leitend gesteuert ist.

6. Empfangsgerät nach einem der Ansprüche 1 bis 5, dadurch gekennzeichnet, daß die Auslesesteuerschaltung (39) oder die Serienschaltung der Auslesesteuerschaltungen (39, 60) zusätzlich die Impulsverzögerungsschaltung (54) ist, derart, daß der Ausgang (46, 80) für das Ablaufendsignal der ersten Auslesesteuerschaltung oder der zweiten Auslesesteuerschaltung der Serienschaltung zusätzlich der Ausgang der Impulsverzögerungsschaltung ist.

7. Empfangsgerät nach einem der vorhergehenden Ansprüche, dadurch gekennzeichnet, daß die Auslesesteuerschaltung(en) (39, 60) einen Rückstelleingang (RS) aufweist (aufweisen), der über eine die Vorderflanke eines Eingangssignals differenzierende Differenzierschaltung (73) mit dem Lesesignalausgang (53) der Einlesesteuerschaltung (20') verbunden ist.

8. Empfangsgerät nach einem der vorhergehenden Ansprüche, dadurch gekennzeichnet, daß die Vergleicherschaltung (31) einen Takteingang (36) aufweist, der an einen Ausgang der logischen Verknüpfungsschaltung (42) angeschlossen ist.

9. Empfangsgerät nach einem der Ansprüche 1 bis 8, dadurch gekennzeichnet, daß der Datenausgang (33) der zweiten Speicherschaltung (34) für die ausgewählten Senderprogrammdaten über einen Schalter (50) an den einen Dateneingang (32) der Vergleicherschaltung (31) angeschlossen ist und daß der Schalter während eines Ausgangssignals der Impulsdehnerschaltung (38) oder eines Lesesignals der Einlesesteuerschaltung (20') elektrisch leitend geschlossen ist.

10. Empfangsgerät nach einem der Ansprüche 1 bis 8, dadurch gekennzeichnet, daß die zweite Speicherschaltung (34) für die ausgewählten Senderprogrammdaten einen Zwischenspeicher (65) enthält, der an den Datenausgang (33) der zweiten Speicherschaltung (34) angeschlossen ist und dessen Datenausgang (70) während des Ausgangssignals der Impulsdehnerschaltung (38) an den einen Dateneingang (32) der Vergleicherschaltung (31) angeschaltet ist, und daß eine Steuerschaltung (66) des Zwischenspeichers an den Ausgang der Vergleicherschaltung angeschlossen ist und bei der Vorderflanke des Ausgangssignals der Impulsdehnerschaltung ein Einspeichersignal für den Zwischenspeicher erzeugt und bei der Rückflanke des Ausgangssignals der Impulsdehnerschaltung ein Löschsignal für den Zwischenspeicher erzeugt.

**Claims**

1. A consumer electronics receiver
- with an electronically tunable tuner circuit (1),
- also with an automatically settable tuning circuit (7, 51) connected to one tuning input (2) of the tuner circuit, comprising a start input (11) for tripping a new tuning setting,
- furthermore with a data separating circuit (16) connected to a signal path (5) connected after the tuner circuit (1) which, from a composite signal present on the signal path (5), separates a station program data record (12) marked by a special type-of-record identification word (13) containing station identification words (14) and station program words (15) in digital signal form and which, moreover, transmits at one data output (D 16) the data words contained in the data record, and produces at one clock output (T 16) the call clock required for the data output,
- and with an evaluating circuit connected to the data output and the call clock output of the data separating circuit (16), in which selected station program data are stored and in which the data of the received station program data record are evaluated with the aid of the selected station program data,
characterized in
- that the evaluating circuit contains a first storage circuit (18) connected to the data output (D16) of the said data separating circuit (16), for the received station program data (14, 15), with a connected read-in control circuit (20), a second storage circuit (34) for storing the selected station program data, with, connected to it, a readout control circuit (39) which is controlled by a clock pulse generator (40), and a comparator (31) connected between the data outputs (29, 33) of said two storage circuits,
- that the output (T16) for the call clock of the data separating circuit is connected to one clock input (T20) of the read-in control circuit (20),
- that to the read-in control circuit (20) there is connected a pulse delay circuit (26, 54) which is capable of being triggered by a signal from said read-in control circuit (20) and, after a time delay (T26) which is equal to or greater than the sum of the time remaining after the trigger signal for reading into the first storage circuit for the received station program data and the read-out time of the two storage circuits, produces an output signal,

- that the output of said pulse delay circuit (26, 54) is connected, via a gate circuit (47), to the start input (9, 52) of said tuning circuit (7),

- that there is connected to the output (37) of the comparator (31) a pulse expander circuit (38) which, at its output, expands each pulse on the input side to a pulse width which is greater than the time between the beginning of two successive processes of reading into the first storage circuit (18) for the received station program data,

- that the output of the pulse expander circuit is connected to the blocking input (Sp) of the gate circuit (47) and

- that to one read signal output (53) of the read-in control circuit (20) and to the output of the pulse expander circuit (38) there is connected a logic operation circuit (42) which, in response to a signal appearing at one of the two outputs, puts said comparator (31) into operation.

2. A receiver as claimed in Claim 1, characterized in that the output of the pulse delay circuit (54) is connected to a reset input (RS, R) of the read-in control circuit (20, 27; 20').

3. A receiver as claimed in Claim 1 or 2, characterized in that said pulse delay circuit (54) is connected to the read signal output (53) of said read-in control circuit (20').

4. A consumer electronics receiver

- with an electronically tunable tuner circuit (1),

- also with an automatically settable tuning circuit (61) connected to one tuning input (2) of the tuner circuit, comprising a start input (62) for tripping a new tuning setting,

- furthermore with a data separating circuit (16) connected to a signal path (5) connected after the tuner circuit which, from a composite signal present on the signal path, separates a station program data record marked by a type-of-record identification word (13), containing station identification words (14) and station program words (15) in digital signal form and which, moreover, transmits at one data output (D16) the data words contained in the data record, and produces at one clock output (T16) the call clock required for the data output,

- and with an evaluating circuit connected to the data output and the call clock output of the data separating circuit, in which selected station program data are stored and in which the data of the received station program data record are evaluated with the aid of the selected station program data,

characterized in

- that the evaluating circuit contains a first storage circuit (18) connected to the data output (D16) of the said data separating circuit (16) for the received station program data (14, 15), with a connected read-in control circuit (20), a second storage circuit (34) for storing the selected station program data, with, connected to it, a read-out control circuit (39) which is controlled by a clock pulse generator (40), and a comparator (31) connected between the outputs (29, 33) of the said two storage circuits,

- that the output (T16) for the call clock of the data separating circuit (16) is connected to one clock input (T20) of the read-in control circuit,

- that there is connected to the output (37) of the comparator (31) a pulse expander circuit (35) which, at its output, expands each pulse on the input side to a pulse width which is greater than the time between the beginning of two successive processes of reading into the first storage circuit for the received station program data,

- that the output (32) of said comparator (31), via a differentiating circuit (75) differentiating the leading edge of the expanded pulse, is connected to the start input (63) of the tuning circuit (61), while one tuning data input (62) of the tuning circuit is connected to the data output (33) of the second storage circuit (34) for the selected station program data, and

- that to one read signal output (53) of said read-in control circuit and to the output of said pulse expander circuit there is connected a logic operation circuit (42) which, in response to a signal appearing at one of the two outputs, puts said comparator into operation.

5. A receiver as claimed in any one of the preceding claims, characterised in

- that said first storage circuit (18') for the received station program data contains a storage line capable of being read out for the station identification word (14) and the station program words (15) of each station contained in the station program data record,

- that there is additionally connected to the storage circuit a further read-out circuit (60) whose clock input (T60) is connected via a switch (72) of the logic operation circuit (42) to the output (46) for an end-of-operation signal of said first read-out control circuit (39).

- and that this switch (72) of said logic operation circuit (42) is controlled in an electrically conducting manner for the duration of a read control signal at the read signal output (53) of the read-in control circuit.

6. A receiver as claimed in any one of Claims 1 to 5, characterized in that said read-out control circuit (39) or the series arrangement of said read-out control circuits (39, 60) is additionally said pulse delay circuit (54), in such a way that the output (46, 80) for the end-of-operation signal of said first read-out control circuit or said second read-out control circuit of the series arrangement additionally acts as the output of said pulse delay circuit.

7. A receiver as claimed in any one of the preceding claims, characterized in that said read- out control circuit (circuits) (39, 60) comprises (comprise) a reset input (RS) which, via a differentiating network (73) differentiating the leading edge of an input signal, is connected to the read signal output (53) of said read-in control circuit (20).

8. A receiver as claimed in any one of the preceding claims, characterized in that said comparator circuit (31) comprises a clock input (36) which is connected to one output of said logic operation circuit (42).

9. A receiver as claimed in any one of Claims 1 to 8, characterised in that the data output (33) of said second storage circuit (34) for the selected station program data is connected via a switch (50) to the one data output (32) of said comparator circuit (31), and that said switch, during an output signal of said pulse expander circuit (38) or a read signal of said read-in control circuit (20), is closed in an electrically conducting manner.

10. A receiver as claimed in any one of Claims 1 to 8, characterized in that said second storage circuit (34) for the selected station program data contains a buffer (intermediate) storage (65) which is connected to the data output (33) of said second storage circuit (34), whils the data output (70) of said buffer storage (65), during the output signal of said pulse expander circuit (38), is connected to the one data input (32) of said comparator circuit (31), and that a control circuit (66) of said buffer storage is connected to the output of said comparator circuit and, in response to the leading edge of the output signal of the pulse expander circuit, produces a read-in signal for the buffer storage and, in response to the trailing edge of the output signal of said pulse expander circuit, produces an erase signal for said buffer storage.

**Revendications**

1. Appareil récepteur d'électronique grand public comportant:
- un circuit d'accord d'entrée (1) pouvant être accordé par voie électronique,
- un circuit d'accord accordable automatiquement (7,51), connecté à une entrée d'accord (2) du circuit d'accord d'entrée, comprenant une entrée de démarrage (11) pour déclencher un nouveau réglage de l'accord,
- un circuit de séparation de données (I6) connecté à un trajet de signal (5) lui-même connecté au circuit d'accord d'entrée (1), lequel, dans un signal composite disponible sur le trajet de signal (5),sépare un message de données de programme de station (12) contenant des mots d'identification de la station (14) et des mots de programme de station (15),sous la forme d'un signal numérique identifié par un mot d'identification de type de message (13) particulier, et lequel, de plus, transmet sur une sortie de données (D16) les mots de données contenus dans le message de données et produit sur une sortie de rythme (T16) le rythme d'appel nécessité par la sortie de données,
- ainsi qu'un circuit d'évaluation connecté à la sortie de données et à la sortie de rythme d'appel du circuit de séparation de données (16) dans lequel des données de programme de station sélectionnéessont enregistrées et dans lequel les données du message de données de programme de station reçu sont évaluées en se référant aux données de programme de station sélectionnées,
caractérisé en ce que:
- le circuit d'évaluation comprend un premier circuit d'enregistrement (18) connecté à la sortie de données (D16) du circuit de séparation de données (16), pour les données de programme de station reçues (14, 15), doté d'un circuit de commande d'inscription (20), ainsi qu'un second circuit d'enregistrement (34) pour conserver des données de programme de station sélectionnées doté d'un circuit de commande de lecture (39) qui est commandé par un générateur d'impulsions de rythme (40), et un comparateur (31) connecté entre les sorties de données (29, 33) des deux circuits d'enregistrement,
- la sortie (T16) pour le rythme d'appel du circuit de séparation de données, est connectée à une entrée de rythme (T20) du circuit de commande d'inscription (20),
- au circuit de commande d'inscription (20) est connecté un circuit de retard d'impulsions (26, 54) pouvant être déclenché par un signal du circuit de commande d'inscription (20) et produisant un signal de sortie, après un délai de retard (t26) égal ou supérieur à la somme du temps nécessaire pour l'inscription des données de programme de station reçues dans le premier circuit d'enregistrement, à partir du signal de déclenchement, et du temps de lecture des deux circuits d'enregistrement,
- la sortie du circuit de retard d'impulsions (26, 54) est connectée, par l'intermédiaire d'un circuit de porte (47), à l'entrée de démarrage (9, 52) dudit circuit d'accord (7),
- à la sortie (37) du comparateur (31) est connecté un circuit extenseur d'impulsions (38) fournissant en sortie, pour chaque impulsion sur son entrée, une impulsion dont la largeur est supérieure à la durée entre les débuts de deux opérations successives d'inscription dans le premier circuit d'enregistrement (18) des données de programme de station reçues,
- la sortie du circuit extenseur d'impulsions est connectée à l'entrée de blocage (Sp) du circuit de porte (47) et
- un circuit logique d'exploitation (42) est connecté à une sortie de signal d'inscription (53) du circuit de commande d'inscription (20) et à la sortie du circuit extenseur d'impulsions (38), lequel, en réponse à un signal apparaissant sur l'une de ces deux sorties, excite ledit comparateur (31).

2. Appareil récepteur selon la revendication 1, caractérisé en ce que la sortie du circuit de retard d'impulsions (54) est connectée à une entrée de remise à zéro (RS, R) du circuit de commande d'inscription (20, 27; 20').

3. Appareil récepteur selon la revendication 1 ou 2, caractérisé en ce que le circuit de retard d'impulsions (54) est connecté à la sortie de signal de lecture (53) du circuit de commande d'inscription (20').

4. Appareil récepteur d'électronique grand public comportant:

- un circuit d'accord d'entrée (1) pouvant être accordé par voie électronique,

- un circuit d'accord accordable automatiquement (61), connecté à une entrée d'accord (2) du circuit d'accord d'entrée, comprenant une entrée de démarrage (62) pour déclencher un nouveau réglage de l'accord,

- un circuit de séparation de données (16) connecté à un trajet de signal (5) lui-même connecté au circuit d'accord d'entrée (1), lequel, dans un signal composite disponible sur le trajet de signal (5), sépare un message de données de programme de station contenant des mots d'identification de la station (14) et des mots de programme de station (15), sous la forme d'un signal numérique identifié par un mot d'identification de type de message (13) particulier, et lequel, de plus, transmet sur une sortie de données (D16) les mots de données contenus dans le message de données et produit sur une sortie de rythme (T16) le rythme d'appel nécessité par la sortie de données,

- ainsi qu'un circuit d'évaluation connecté à la sortie de dornées et à la sortie de rythme d'appel du circuit de séparation de données (16) dans lequel des données de programme de station sélectionnées sont enregistrées et dans lequel les données du message de données de programme de station reçu sont évaluées en se référant aux données de programme de station sélectionnées, caractérisé en ce que:

- le circuit d'évaluation comprend un premier circuit d'enregistrement (18) connecté à la sortie de données (D16) du circuit de séparation de données (16), pour les données de programme de station reçues (14, 15), doté d'un circuit de commande d'inscription (20), ainsi qu'un second circuit d'enregistrement (34) pour conserver des données de programme de station sélectionnées doté d'un circuit de commande de lecture (39) qui est commandé par un générateur d'impulsions de rythme (40), et un comparateur (31) connecté entre les sorties de données (29, 33) des deux circuits d'enregistrement.

- la sorti (T16) pour le rythme d'appel du circuit de séparation de données, est connectée à une entrée de rythme (T20) du circuit de commande d'inscription (20),

- à la sortie (37) du comparateur (31) est connecté un circuit extenseur d'impulsions (38) fournissant en sortie, pour chaque impulsion sur son entrée, une impulsion dont la largeur est supérieure à la durée entre les débuts de deux opérations successives d'inscription dans le premier circuit d'enregistrement (18) des données de programme de station reçues,

- la sortie (37) du comparateur (31) est connectée, par l'intermédiaire d'un réseau différentiateur (75) différentiant le flanc arrière de l'impulsion étendue, à l'entrée de démarrage (63) du circuit d'accord (61), alors qu'une entrée de données d'accord (62) de ce circuit d'accord est connectée à la sortie de données (33) dudit circuit d'enregistrement (34) pour les données de programme de station sélectionnées, et

- un circuit logique d'exploitation (42) est connecté à une sortie de signal de lecture (53) du circuit de commande d'inscription (20) et à la sortie du circuit extenseur d'impulsions (42), lequel, en réponse à un signal apparaissant sur l'une de ces deux sorties, excite ledit comparateur.

5. Appareil récepteur selon l'une quelconque des revendications précédentes, caractérisé en ce que:

- le premier circuit d'enregistrement (18') pour les données de programme de station reçues comprend, pour le mot d'identification de la station (14) et le mot de programme de station (15) contenus dans le message de données de programme de station, une ligne d'enregistrement pouvant être lue,

- un autre circuit de commande de lecture (60) est en outre connecté au premier circuit d'enregistrement (18') dont l'entrée de rythme (T60) est connectée, par l'intermédiaire d'un commutateur (72) du circuit logique d'exploitation (42) à une sortie (46), fournissant un signal de fin de cycle, du premier circuit de commande de lecture (39),

- ce commutateur (72) du circuit logique d'exploitation (42), est rendu conducteur pendant la durée d'un signal de commande de lecture à la sortie (53) de signal de lecture du circuit de commande d'inscription.

6. Appareil récepteur selon l'une des revendications 1 à 5 caractérisé en ce que le circuit de commande de lecture (39), ou le montage en série des circuits de commande de lecture (39, 60) s'ajoute au circuit de retard d'impulsions (54) de sorte que la sortie (46, 80) du signal de cycle du premier circuit de commande de lecture, ou du deuxième circuit de commande de lecture du montage en série, agit comme la sortie du circuit de retard d'impulsions.

7. Appareil récepteur selon l'une quelconque des revendications précédentes, caractérisé en ce que le(s) circuit(s) de commande de lecture (39, 60) comporte(nt) une entrée de remise à zéro (R8) laquelle, par l'intermédiaire d'un réseau différentiateur (73) différentiant le flanc arrière d'un signal d'entrée, est connectée à la sortie de signal de lecture (53) du circuit de commande d'inscription (20').

8. Appareil récepteur selon l'une quelconque des revendications précédentes, caractérisé en ce que le comparateur (31) comporte une entrée de rythme (36) qui est connectée à une sortie du circuit logique d'exploitation (42).

9. Appareil récepteur selon l'une quelconque des revendications 1 à 8, caractérisé en ce que la sortie de données (33) du deuxième circuit d'enregistrement (34) des données de programme de station sélectionnées est connectée, par l'intermédiaire d'un commutateur (50) à une entrée de données (32) du comparateur (31) et en ce que ce commutateur est rendu électriquement conducteur pendant la durée du signal de sortie du circuit extenseur d'impulsions (38) ou d'un signal de lecture du circuit de commande d'inscription (20').

10. Récepteur selon l'une quelconque des renvendications 1 à 8, caractérisé en ce que ledit circuit d enregistrement (34) pour les données de programme de station sélectionnées, comprend une mémoire intermédiaire (65) connectée à la sortie de données (33) du circuit d'enregistrement (34) et dont la sortie (70), durant le signal de sortie du circuit extenseur d'impulsions (38) peut être connectée à une entrée de données (32) du comparateur (31), et en ce qu'un circuit de commande (66) de la mémoire intermédiaire est connecté à la sortie du circuit comparateur et, en réponse au front avant du signal de sortie du circuit extenseur d'impulsions, engendre un signal de lecture pour la mémoire intermédiaire et, en réponse au flanc arrière du signal de sortie du circuit extenseur d'impulsions, produit un signal d'effacement pour ladite mémoire intermédiaire.

Fig.1

Fig.3

Fig.2

Fig.5

Fig.4